Europäisches Patentamt

European Patent Office

Office européen des brevets

(19)

(11) Publication number : **0 443 717 A2**

## (12) EUROPEAN PATENT APPLICATION

(21) Application number : 91300390.1

(22) Date of filing : 18.01.91

(51) Int. Cl.⁵ : **H05K 3/36, H05K 9/00**

(30) Priority : 21.01.90 JP 4096/90 U
21.01.90 JP 4097/90 U

(43) Date of publication of application :
28.08.91 Bulletin 91/35

(84) Designated Contracting States :
**DE FR GB**

(71) Applicant : **SONY CORPORATION**
**7-35 Kitashinagawa 6-Chome Shinagawa-ku**
**Tokyo 141 (JP)**

(72) Inventor : **Tanaka, Masato, c/o Patents Div.**
**Sony Corp., 6-7-35, Kitashinagawa**
**Shinagawa-ku, Tokyo 141 (JP)**

(74) Representative : **Purvis, William Michael**
**Cameron et al**
**D. Young & Co. 10 Staple Inn**
**London WC1V 7RD (GB)**

(54) Component mounting circuit board.

(57)     A component mounting circuit board (30) comprises a flexible member (31) having a plurality of component mounting portions (32A to 32D, 33A to 33D) and a plurality of foldable portions (34A to 34C) in alternating relation along a given direction of the flexible member (31). Pre-determined electronic components (35A to 35D, 36A to 36D) are mounted on at least one side of the flexible member (31) at the component mounting portions (32a to 32D, 33A to 33A). The flexible member 31 is folded at the foldable portions (34A to 34C) to superpose the component mounting portions are above another in a plurality of layers. The flexible member may have a plurality of extension portions extending from the component mounting portions, shield patterns can be formed on the extension portions, and the extension portions can be folded even so as to shield the electronic components.

FIG.7

## COMPONENT MOUNTING CIRCUIT BOARD

The invention relates to a component mounting circuit board.

Heretofore, various component mounting methods have been adopted to mount electronic components at a high density.

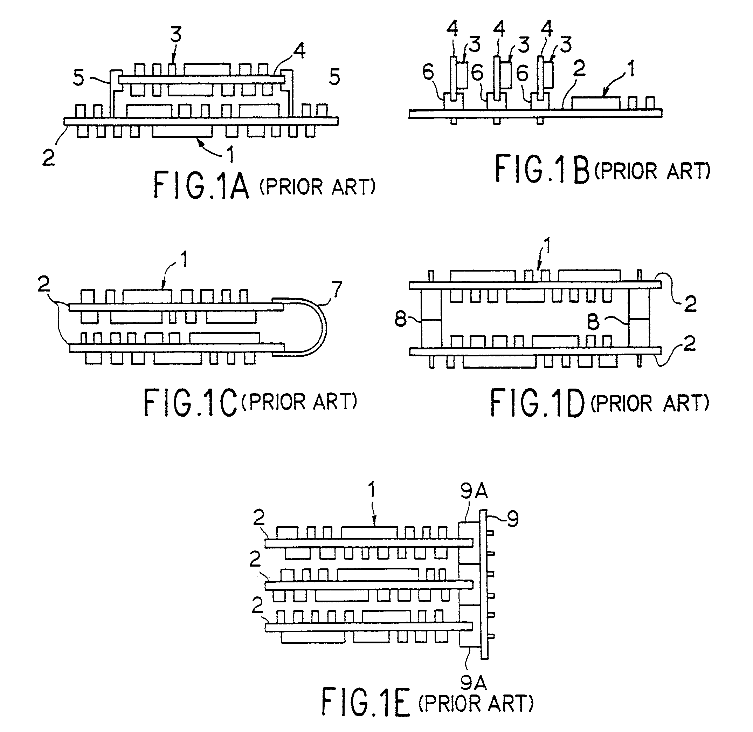

For example, in the component mounting method shown in Figure 1A of the accompanying drawings, a sub-circuit board 4, on which electronic components 3 or hybrid integrated circuits and the like are assembled, is mounted on a main circuit board 2 in a parallel manner. Electronic components 1 including chips and integrated circuits (ICs) are mounted on the main circuit board 2 as shown in Figure 1. Connection pins 5 or similar members of the sub-circuit board 4 are soldered to the main circuit board 2.

In another component mounting method, illustrated in Figure 1B, sub-circuit boards 4, on which electronic components 3 are mounted, and hybrid integrated circuits are mounted vertically on a main circuit board 2 by means of connectors 6. Additional electronic components 1 are mounted on the main circuit board 2.

In still another component mounting method, shown in Figure 1C, a plurality of circuit boards 2 on which electronic components 1 are mounted are stacked one above the other, and the circuit boards 2 are inter-connected by means of a flexible circuit board or a flat cable 7.

In another component mounting method, shown in Figure 1D, a plurality of circuit boards 2, on which electronic components 1 are mounted, are stacked one above the other, and the circuit boards 2 are inter-connected by means of circuit board connectors 8.

According to another component mounting method, shown in Figure 1E, a plurality of circuit boards 2, on which electronic components 1 are mounted, are connected to a mother board 9 by means of plurality of connectors 9A.

In all the cases described above, electronic components 1 and/or 3 are assembled at as high a density as possible. However, in all of these component mounting methods, separate connecting means are needed to inter-connect the circuit boards 2, 4, and/or 9, and thus areas to accommodate such connection means are necessary on the circuit boards. Especially when electronic appliances are to be miniaturised, this factor cannot be neglected. As a result, the maximum mounting density is considerably compromised.

In practice, the devices used previously have a mass and volume that are increased by the mass and thickness of the circuit boards. This militates against reduction in the size of electronic appliances.

Moreover, in a component mounting method in which a plurality of circuit boards are stacked as in the prior art, it is not possible to perform a test during operation unless test points are provided to which leads can be attached. The provision of such test points compromises component density, and the absence of such test points compromises maintenance and operability.

In Figure 2, a so-called shielding box 13 is used to shield a circuit board 11 and electronic components 12 mounted on a front surface of the circuit board 11. The electronic components 12 include, for example, integrated circuits, resistances and condensers in the form of chips.

Figure 3 shows that the shielding box 13 has frame-shaped side walls 13A and a lid 13B designed to cover the side walls 13A. The side walls 13A and the lid 13B are made of electrically conductive metallic plates.

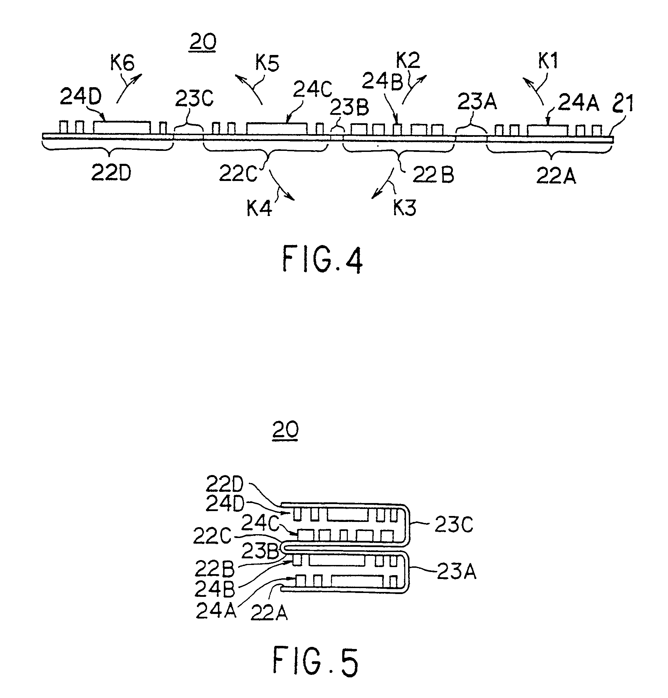

Mounting portions 14A, 14B, 14C and 14D are provided on the respective side walls 13A of the shielding box 13 to mount the shielding box 13 on the front surface of the circuit board 11. The mounting portions 14A to 14D are formed integrally with respective central portions of the lower sides of the side walls 13A. The mounting portions 14A to 14D have rod-like solder fixing legs 15A, 15B, 15C and 15D (the latter not visible in Figure 3) integrally formed at respective distal ends thereof.

By means of this structure, the side walls 13A of the shielding box 13 are electrically and mechanically mounted on the circuit board 11 by inserting the solder fixing legs 15A, 15B, 15C and 15D into mounting through-holes formed in the circuit board 11 and are soldered there.

The side walls 13A are provided with through-holes 16A, 16B, 16C and 16D formed in middle portions of respective sides thereof. In a state in which the lid 13B is secured to the side walls 13A, semi-spherical projections 17A, 17B, 17C, and 17D formed at middle portions of respective inner sides of the lid portion 13B come into engagement with the through-holes 16A to 16D. The lid 13B can thus be locked in a condition in which it covers the side walls 13A.

The shielding box 13 constructed in this manner has substantial size and weight. Moreover, it is more difficult to mount the shielding box than the electronic components 12, and additional steps are needed to mount it.

It is also difficult to test or replace electronic components on the circuit board 11 even with the lid 13B removed, since the side walls 13A of the shielding box 13 are permanently secured to the circuit board 11 by soldering. Hence maintenance and operability suffer.

In addition, the use of the shielding box 13 in a flexible circuit board on which electronic components 12 are mounted largely defeats the whole purpose of the flexible circuit board, since the shielding box 13 limits flexibility and adds weight and thickness. The use of a shielding box is thus in-sufficient for practical purposes.

According to one aspect of the invention there is provided a component mounting circuit board comprising:

a flexible member having a plurality of component mounting portions and a plurality of foldable portions in alternating relation along a given direction of the flexible member; and

electronic components mounted on at least one side of the flexible member at the component mounting portions;

the flexible member being folded at the foldable portions to superpose one of the component mounting portions above at least one other of the component mounting portions in a plurality of layers.

Such a component mounting circuit board can be capable of mounting electronic components at a spatially high density.

According to another aspect of the invention there is provided a component mounting circuit board comprising:

a flexible member having at least one component mounting portion and a plurality of extension portions extending from the component mounting portion;

electronic components mounted on at least one side of the flexible member at the component mounting portion; and

shield patterns formed on the extension portions;

the extension portions being folded so as to shield the electronic components.

A light and thin shielding unit can thus be provided to give a shielding effect.

The invention is diagrammatically illustrated by way of example in the accompanying drawings, in which Figures 1A, 1B, 1C, 1D and 1E are diagrammatic side views illustrating conventional methods of mounting electronic components;

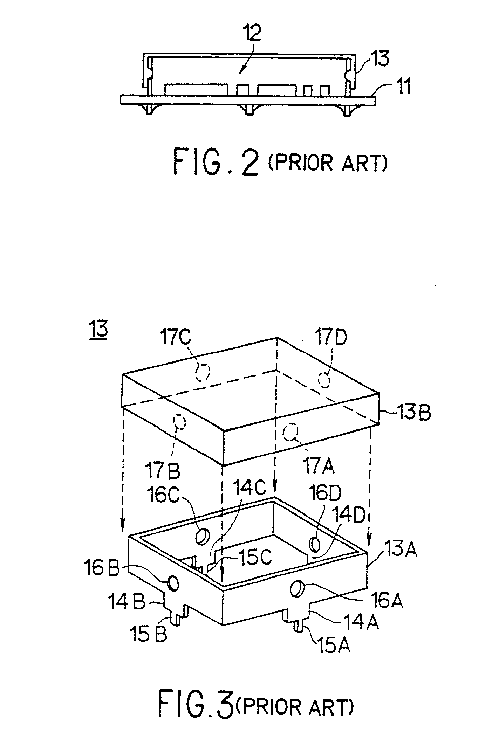

Figure 2 is a diagrammatic view illustrating a conventional shielding box for shielding a circuit board;

Figure 3 is a diagrammatic, exploded perspective view of the shielding box of Figure 2;

Figure 4 is a side view showing an unfolded first embodiment of a component mounting circuit board according to the invention;

Figure 5 is a side view illustrating the component mounting circuit board of Figure 4 in a mounted, folded state;

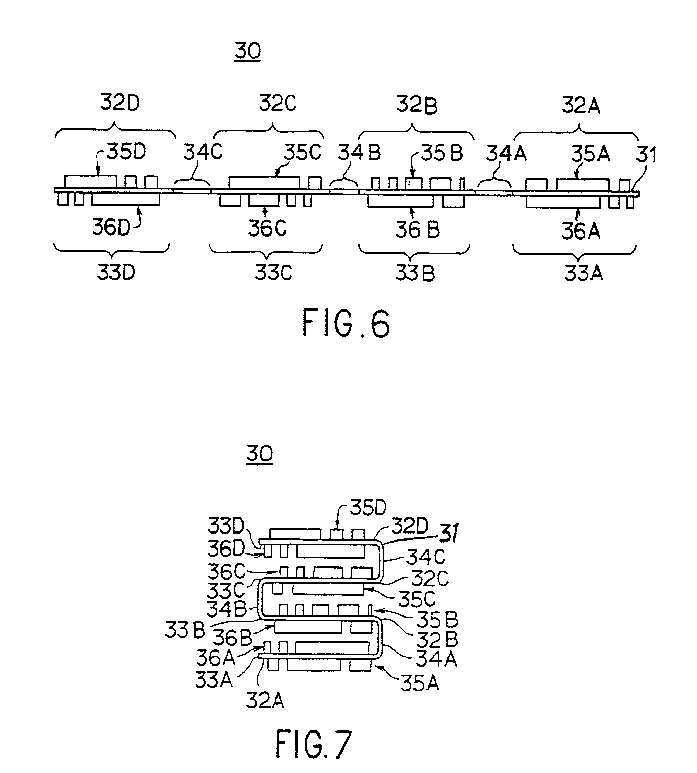

Figure 6 is a side view showing an unfolded second embodiment of a component mounting circuit board according to the invention;

Figure 7 is a side view showing the component mounting circuit board of Figure 6 in a mounted, folded state;

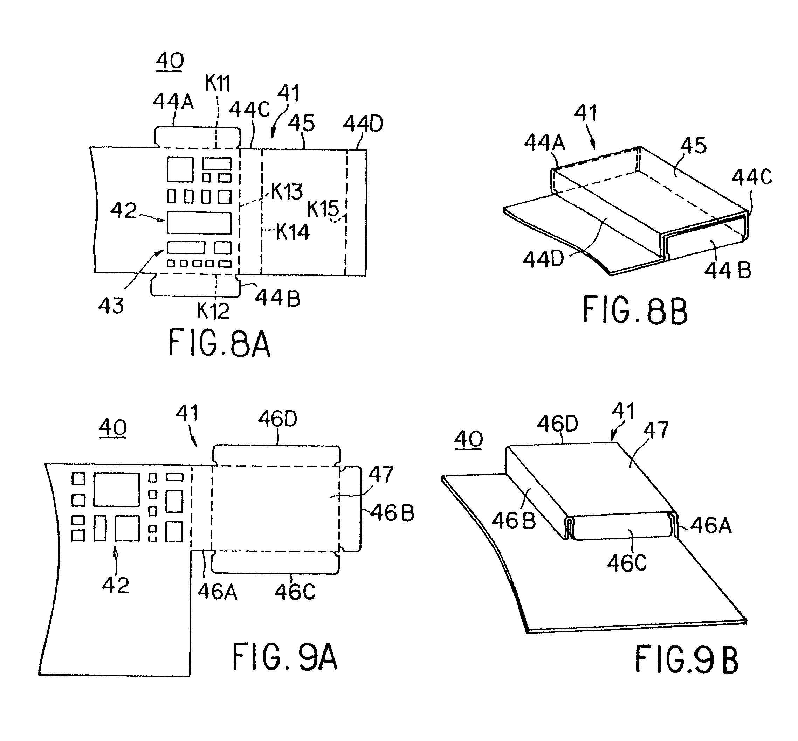

Figures 8A and 8B are respectively top plan and perspective diagrammatic views showing a first embodiment of a shielding unit of a component mounting circuit board according to the invention; and

Figures 9A and 9B are respectively top plan and perspective diagrammatic views showing a second embodiment of a shielding unit of a component mounting circuit board according the invention.

Referring to Figure 4, a component mounting circuit board 20 includes a flexible member or circuit board 21 in the shape of a rectangle. Extending between the longer edges of the flexible circuit board 21, there are formed component mounting portions 22A to 22D and foldable portions 23A to 23C.

In practice, on the front surface of each of the component mounting portions 22A to 22D of the component mounting circuit board 20 there are mounted electronic components 24A to 24D such as predetermined chip components and integrated circuits in accordance with the circuit pattern.

After the electronic components 24A to 24D have been assembled, the flexible circuit board 21 is first folded at the first foldable portion 23A as indicated by arrows K1 and K2 to bring the first and the second component mounting portions 22A and 22B into proximity to each other. The flexible circuit board 21 is subsequently folded at the second foldable portion 23B as shown by arrows K3 and K4 to bring rear surfaces of the second and the third component mounting portions 22B and 22C into substantial contact with each other, and the flexible circuit board 21 is then bent at the third foldable portion 23C as shown by arrows K5 and K6 so that the mount surface of the third and the fourth component mounting portions 22C and 22D come into proximity to each other. As a result, the flexible circuit board 21 as a whole is folded in concertina manner.

As can be seen from Figure 5, the flexible circuit board 21 forms the component mounting circuit board 20 as a single mount having four storeys. In practice, it is not necessary to inter-connect the component mounting portions 22A to 22D, and thus the mount density is markedly enhanced.

In the construction described above, while the flexible circuit board is still flat (i.e. before it is folded), the pre-determined electronic components 22A to 24D are assembled on the component mounting portions 22A to 22D that are formed on the flexible circuit board 21 in alternating relation with the foldable portions 23A to 23C. Then the flexible circuit board 21 is folded at the foldable portions 23A to 23C to form a single mount having a four-storey structure. Thus there is provided a component mounting circuit board 20 that is capable of markedly increasing the mounting density without any extra inter-connection between boards.

Moreover, in the construction described above, the component mounting circuit board is constituted by the single flexible circuit board 21, and thereby the electronic components 24A to 24D can be automatically mounted. Thus the mounting process is much simplified and the reliability is enhanced. Since the flexible circuit board 21 is thin, the component mounting circuit board 20 is most suitable for reducing electronic appliances in weight and volume.

In addition, in the construction described above, circuit patterns of the component mounting portions 22A to 22D and the assembled electronic components 24A to 24D can be exposed by unfolding the foldable portions 23A to 23C when necessary. Thus, any part of the electronic components 24a to 24D can be tested during operation, and this significantly enhances operability.

In the embodiment described above, the electronic components 24A to 24D are assembled on only one surface of the flexible circuit board 21.

As Figure 6 shows however, component mounting portions 32A and 33A, 32B and 33B, 32C and 33C, and 32D and 33D may be arranged on opposite surfaces of a flexible member or circuit board 31 and may be provided with electronic components 35A and 36A, 35B and 36B, 35C and 36C and 35D and 36D, respectively. The flexible circuit board may be then folded at foldable portions 34A to 34C like a folding screen as described, so that, as Figure 7 shows, the flexible circuit board 31 forms a component mounting circuit board 30 having a double mount, eight-storey structure.

In the embodiment of Figures 4 and 5, the flexible circuit board 21 forms the component mounting circuit board 20 having a single mount, four-storey structure, but the component mounting circuit board 20 may be provided with additional layers to produce an eight-storey effect similar to the effect of the embodiment of Figures 6 and 7. In fact, in the embodiments of Figures 4 to 7, the structures can have any number of storeys.

In the embodiment of Figures 4 and 4, no electronic components are mounted on the foldable portions 23A to 23C, but a similar effect of the embodiment illustrated in Figures 4 and 5 may be produced by assembling pre-determined electronic components at middle portions of the folded sides and the rear sides of the foldable portions 23A to 23C. In the latter case, the opposite edge portions of the portions 23A to 23C practically constitute folding portions while middle portions thereof can constitute component mounting portions.

Referring to Figures 8A and 8B, a circuit board 40 has a flexible circuit board structure provided with a shielding unit 41. The circuit board 40 has a component mounting portion 43 on the front surface on which pre-determined electronic components 42 are mounted. The component mounting portion 43 extends in multiple directions.

As Figure 8A shows, extension portions of the flexible circuit board include first and second side wall portions 44A and 44B, a third side wall portion 44C, a fourth side wall portion 44D, and a lid portion 45. The side wall portions 44A and 44B have pre-determined oblong shape and are connected to respective shorter sides of the component mounting portion 43 while the side wall portion 44C is connected to a longer side of the component mounting portion 43. The side wall portion 44C, the lid portion 45 and the side wall portion 44D are connected together serially.

The third side wall portion 44C has pre-determined oblong shape. The lid portion 45 has the same rectangular shape as the component mounting portion 43. The fourth side wall portion 44D has the same rectangular shape as the third side wall portion 44C.

The first to the fourth side wall portions 44A to 44D and the lid portion have planar earth patterns formed on them, and the earth patterns are connected.

In this embodiment, the first and the second side wall portions 44A and 44B are bent as shown in Figure 8B toward the component mounting portion 43 along respective fold lines K11 and K12, while the third side wall portion 44C, the lid portion 45 and the fourth side wall portion 44D are bent toward the component mounting portion 43 along respective folding lines K13, K14 and K15.

Thus, the component mounting portion 43, which has the electronic components 42 mounted on its front surface, is covered with the first to the fourth side wall portions 44A to 44D and the lid portion 45, which have the earth patterns formed on them, and the shielding unit 41, which has a shield effect as a whole, is thereby formed.

In the construction described above, the component mounting portion 43, having the electronic components 42 mounted on it, is extended, and the planar earth patterns are formed on the extended portions of the flexible circuit board to cover the component mounting portion 43. Thus there is provided the shielding unit 41, which provides a sufficient shield effect even though it is thin and weighs very little.

Moreover, in the construction of Figures 8A and 8B, the shielding unit 41 is formed integrally with the flexible circuit board and then folded. This greatly simplifies the production process. The component mounting portion 43 can be easily tested and the electronic components 42 replaced with ease by unfolding the shielding unit 41.

In the embodiment of Figures 8A and 8B there is described a case where the whole of the component mounting portion 43 is covered by shielding. As shown in Figures 9A and 9B, in which parts corresponding to parts of Figures 8A and 8B are designated by the same reference characters, when electronic components 42 to be shielded are mounted at a corner of the circuit board 40, side walls 46A to 46D and a lid 47 may be formed in corresponding shapes, and thereby an effect similar to the effect of the embodiment shown in Figures 8A and 8B can be achieved.

In the embodiment of Figures 8A and 8B, the side wall portions 44A to 44D and the lid portion 45 are formed as extensions of the flexible circuit board and cover the whole of the component mounting portion 43. When a noise generating direction is fixed and known in advance, the shield unit may instead have a shape such as to provide shielding only in the direction from which the noise emanates. Such a shield unit can produce an effect similar to that achieved in the embodiments described above.

Moreover, in the embodiment of Figures 8A and 8B, the side wall portions 44A to 44D and the lid 45 have planar earth patterns formed on them. In place of the planar earth patterns, mesh-like earth patterns may be used to make the shield unit even lighter.

## Claims

1. A component mounting circuit board (20, 30) comprising:

   a flexible member (21, 31) having a plurality of component mounting portions (22A to 22D, 32A to 32D, 33A to 33D) and a plurality of foldable portions (23A to 23C, 34A to 34C) in alternating relation along a given direction of the flexible member; and

   electronic components (34A to 24D, 35A to 35D, 36A to 36D) mounted on at least one side of the flexible member at the component mounting portions;

   the flexible member (31) being folded at the foldable portions (23A to 23C, 34A to 34C) to superpose one of the component mounting portions above at least one other of the component mounting portions in a plurality of layers.

2. A component mounting circuit board according to claim 1, wherein the flexible member (21, 31) includes at least three folds to form at least four storeys of electronic components.

3. A component mounting circuit board according to claim 1, further comprising electronic components mounted on another side of the flexible member (21, 31) at the component mounting portions.

4. A component mounting circuit board according to claim 3, wherein the flexible member (21, 31) includes at least three folds to form at least eight storeys of the electronic components.

5. A component mounting circuit board (40) comprising:

   a flexible member having at least one component mounting portion (43) and a plurality of extension portions (44A to 44D, 46A to 46D) extending from the component mounting portion (43);

   electronic components (42) mounted on at least one side of the flexible member at the component mounting portion (43); and

   shield patterns formed on the extension portions;

   the extension portions (44A to 44D, 46A to 46D) being folded so as to shield the electronic components (42).

6. A component mounting circuit board according to claim 5, wherein the electronic components (42) have an upper portion, side portions and a lower portion and the extension portions (44a to 44D, 46A to 46D) enclose at least the upper and side portions.

FIG.1A (PRIOR ART)

FIG.1B (PRIOR ART)

FIG.1C (PRIOR ART)

FIG.1D (PRIOR ART)

FIG.1E (PRIOR ART)

FIG. 2 (PRIOR ART)

FIG.3 (PRIOR ART)

FIG.4

FIG.5

FIG.6

FIG.7

FIG.8B

FIG.8A

FIG.9B

FIG.9A